# EUROPEAN PATENT APPLICATION

(11) **EP 4 333 029 A1**
(43) Date of publication of application: **06.03.2024**
(21) Application number: 22795719.8
(22) Date of filing: 25.04.2022
(51) Int. Cl.: H01L 21/52, H01L 23/48, H01L 25/07, H01L 25/18

(54) **SEMICONDUCTOR MODULE AND METHOD FOR MANUFACTURING SEMICONDUCTOR MODULE**

(30) Priority: 30.04.2021 JP 2021077596; 30.04.2021 JP 2021077623
(71) Applicant: Panasonic Holdings Corporation, Osaka 571-8501 (JP)
(72) Inventor: MAEDE, Masato, Kadoma-shi, Osaka 571-0057 (JP); NIIMI, Hideki, Kadoma-shi, Osaka 571-0057 (JP); KITAURA, Hidetoshi, Kadoma-shi, Osaka 571-0057 (JP)
(74) Representative: Novagraaf International SA
(86) International application number: PCT/JP2022/018722
(87) International publication number: WO 2022/230806

(57) **Abstract**

A semiconductor module comprises a semiconductor element, a joining part configured including a sintered metal, a substrate member, and a lead frame. The joining part comprises: at least one element joining member that joins the semiconductor element and a main surface of the substrate member; and at least one lead frame joining member that joins the lead frame and the main surface of the substrate part, the at least one lead frame joining member having a small-piece form with the same volume as the element joining member.

## Description

### Technical Field

The present disclosure relates to a semiconductor module and a method for manufacturing the semiconductor module.

### Background Art

There are many apparatuses of which the power source voltage and the drive voltage differ from each other, such as electric vehicles and air-conditioners. Such apparatuses require power conversion apparatuses such as inverters or converters. The power conversion apparatus uses a power module equipped with power semiconductors composed of an insulated gate bipolar transistor (IGBT), silicon carbide (SiC) or gallium nitride (GaN). The semiconductor element is bonded to one main surface of the insulation substrate in the power module. Further, the use of a sintering bonding material for bonding the semiconductor element and the insulation substrate has been proposed as disclosed in PTL 1.

### Citation List

### Patent Literature

PTL 1
WO2017/077729

### Summary of Invention

### Technical Problem

The semiconductor element and the substrate member should be reliably bonded. An object of the present disclosure is to provide a semiconductor module and a method for manufacturing the semiconductor module that can suppress bonding defects of the semiconductor element and the substrate member.

### Solution to Problem

A semiconductor module of the present disclosure includes a semiconductor element, a bonding part including a sintered metal, a substrate member, and a lead frame. The bonding part includes: at least one element bonding member configured to bond the semiconductor element and a main surface of the substrate member, and at least one lead frame bonding member configured to bond the lead frame and the main surface of the substrate member and having a small piece shape with the same volume as the element bonding member.

A method for manufacturing a semiconductor module of the present disclosure includes applying sintering bonding materials at a plurality of positions different from each other on a main surface of a substrate member such that the sintering bonding materials have shapes with the same volume as each other; pre-drying the sintering bonding materials, placing a semiconductor element on some of the sintering bonding materials applied on the main surface, and placing a lead frame on other of the sintering bonding materials applied on the main surface and bonding the semiconductor element and the substrate member and bonding the lead frame and the substrate member by sintering the sintering bonding materials.

### Advantageous Effects of Invention

The semiconductor module and the method for manufacturing the semiconductor module of the present disclosure that can suppress bonding defects of the semiconductor element and the substrate member.

### Brief Description of Drawings

FIG. 1 is a longitudinal sectional view of a semiconductor module according to a first embodiment;
FIG. 2 is a plan view illustrating an arrangement of an element bonding member and a lead frame bonding member of the semiconductor module according to the first embodiment;
FIG. 3A is an explanatory diagram of a method for manufacturing the semiconductor module in a cross-section taken along line III-III of FIG. 2;
FIG. 3B is an explanatory diagram of the method for manufacturing the semiconductor module in a cross-section taken along line III-III of FIG. 2;
FIG. 3C is an explanatory diagram of the method for manufacturing the semiconductor module in a cross-section taken along line III-III of FIG. 2;
FIG. 3D is an explanatory diagram of the method for manufacturing the semiconductor module in a cross-section taken along line III-III of FIG. 2;
FIG. 3E is an explanatory diagram of the method for manufacturing the semiconductor module in a cross-section taken along line III-III of FIG. 2;
FIG. 3F is an explanatory diagram of the method for manufacturing the semiconductor module in a cross-section taken along line III-III of FIG. 2;
FIG. 4 is a plan view illustrating a state after application of a sintering bonding material according to the first embodiment;
FIG. 5 is a sectional view taken along line V-V of FIG. 4;
FIG. 6 is a longitudinal sectional view of a semiconductor module according to a second embodiment;
FIG. 7 is a plan view illustrating a shape of an element bonding member of the semiconductor module according to the second embodiment;
FIG. 8A is an explanatory diagram of a method for manufacturing the semiconductor modules according to the second and third embodiments;
FIG. 8B is an explanatory diagram of a method for manufacturing the semiconductor modules according to the second and third embodiments;
FIG. 8C is an explanatory diagram of a method for manufacturing the semiconductor modules according to the second and third embodiments;
FIG. 8D is an explanatory diagram of a method for manufacturing the semiconductor modules according to the second and third embodiments;
FIG. 8E is an explanatory diagram of a method for manufacturing the semiconductor modules according to the second and third embodiments;
FIG. 9 is a plan view illustrating a state after application of a sintering bonding material according to the second and third embodiments; and
FIG. 10 is a plan view illustrating a shape of an element bonding member of the semiconductor module according to the third embodiment.

### Description of Embodiments

### First Embodiment

A first embodiment of the present disclosure is described below.

### Structure of Semiconductor Module

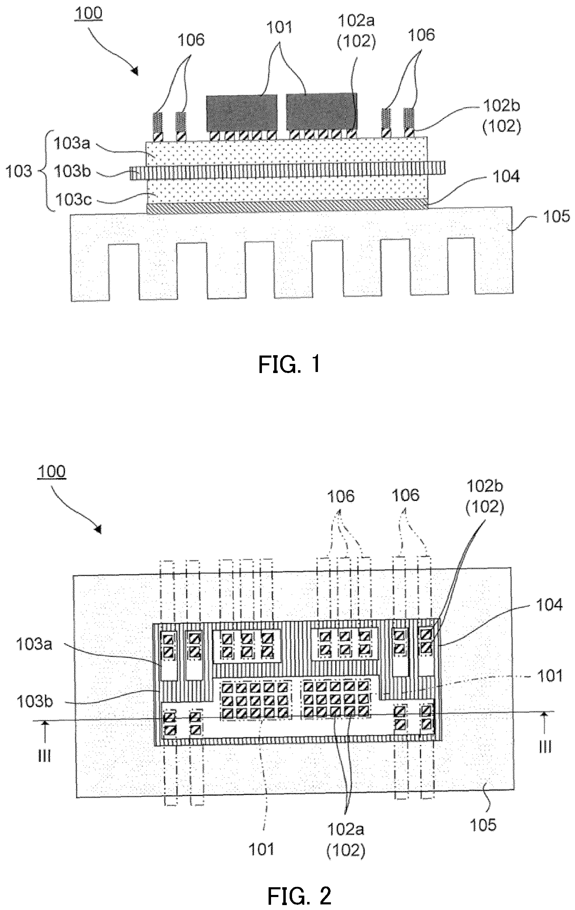

First, a structure of a semiconductor module of the first embodiment is described. FIG. 1 is a longitudinal sectional view of the semiconductor module.

As illustrated in FIG. 1, semiconductor module 100 includes semiconductor element 101, bonding part 102, substrate member 103, heat dissipation member 104, heat sink 105, and lead frame 106. Note that in FIG. 1, the illustration of the signal terminals and the power source of semiconductor element 101 is omitted.

Semiconductor element 101 is a power semiconductor element composed of an insulated gate bipolar transistor, silicon carbide, gallium nitride, or the like. An electrode not illustrated in the drawing is formed at the bottom surface of semiconductor element 101. The electrode is composed of a metalized layer formed of nickel plating and gold plating so that semiconductor element 101 is firmly bonded to element bonding member 102a of bonding part 102 described later. An electrode composed of a metalized layer formed of nickel plating and gold plating is also formed at the top surface of semiconductor element 101. Note that while semiconductor module 100 includes two semiconductor elements 101 in the first embodiment, semiconductor module 100 may include one semiconductor element 101 or three or more semiconductor elements 101.

Bonding part 102 includes element bonding member 102a and lead frame bonding member 102b. Element bonding member 102a and lead frame bonding member 102b are formed through sintering of a sintering bonding material. Element bonding member 102a and lead frame bonding member 102b include a sintered metal formed through sintering of particles with a nanometer size (hereinafter referred to as "nanoparticles") composed mainly of silver, copper, nickel or gold. With the sintered metal mainly composed of silver, the thermal conductivity of element bonding member 102a and lead frame bonding member 102b can be increased. In addition, with the sintered metal mainly composed of copper, the thermal conductivity of element bonding member 102a and lead frame bonding member 102b can be increased, while reducing the cost than using silver. Further, with the sintered metal mainly composed of nickel, the mechanical strength of element bonding member 102a and lead frame bonding member 102b can be increased. In addition, with the sintered metal mainly composed of gold, the stress absorption through elastic deformation of element bonding member 102a and lead frame bonding member 102b can be increased. By atomizing the metal particle to nanometer sizes, the surface energy of the particle increases. Therefore, the sintering can be achieved at a lower temperature in comparison with the case where micrometer-sized metal particles are used. Note that solder, Sn-based alloy and the like may be used as the material of element bonding member 102a and lead frame bonding member 102b. Further, element bonding member 102a and lead frame bonding member 102b may include a sintered metal through sintering of particles with a micrometer size mainly composed of a metal such as silver, copper, nickel and gold. Element bonding member 102a bonds semiconductor element 101 and substrate member 103. Lead frame bonding member 102b bonds substrate member 103 and lead frame 106. Specific configurations of element bonding member 102a and lead frame bonding member 102b are described later.

Substrate member 103 is a so-called DBC (Direct Bonded Copper) substrate composed of metal heat transfer plate 103a, insulation substrate 103b and metal heat dissipation plate 103c.

Metal heat transfer plate 103a is a plate-shaped member disposed at the top surface of heat insulation substrate 103b, and is formed of copper. Metal heat transfer plate 103a transfers the heat emitted by semiconductor element 101, to metal heat dissipation plate 103c through insulation substrate 103b. Metal heat transfer plate 103a forms a circuit pattern. Semiconductor element 101 is bonded to metal heat transfer plate 103a with element bonding member 102a. In addition, metal heat transfer plate 103a is connected to the electrode of the top surface semiconductor element 101 with a wire not illustrated in the drawing. In addition, metal heat transfer plate 103a is bonded to lead frame 106 with lead frame bonding member 102b. Through lead frame 106, the power is supplied to semiconductor element 101 and the communication between semiconductor element 101 and the external apparatus is performed. A metalized layer not illustrated in the drawing is formed at metal heat transfer plate 103a so that metal heat transfer plate 103a is firmly bonded to element bonding member 102a and lead frame bonding member 102b.

Insulation substrate 103b is composed of a ceramic compound such as Al2O3, Si3N4 and AlN, and has an insulating property.

Metal heat dissipation plate 103c is a plate-shaped member disposed at the bottom surface of insulation substrate 103b, and is formed of copper. Metal heat dissipation plate 103c widely transfers, to the surrounding portions, the heat emitted by semiconductor element 101.

Heat dissipation member 104 bonds metal heat dissipation plate 103c and heat sink 105. Heat dissipation member 104 widely transfers, to the surrounding portions, the heat emitted by semiconductor element 101, and thus prevents the malfunction and fracture of semiconductor module 100 due to the temperature rise of semiconductor element 101. Solder, silicone or the like is used as heat dissipation member 104.

Heat sink 105 plays a role of emitting the heat emitted by semiconductor element 101, to surrounding portions through air-cooling. A plurality of fins is formed at the bottom surface of heat sink 105. The material of heat sink 105 is aluminum or the like.

Lead frame 106 is a portion for connecting semiconductor module 100 to an external substrate. Lead frame 106 is formed by etching a thin plate of copper alloy or iron alloy, for example.

Next, specific configurations of element bonding member 102a and lead frame bonding member 102b are described. FIG. 2 is plan view illustrating an arrangement of the element bonding member and the lead frame bonding member of the semiconductor module.

As illustrated in FIG. 2, element bonding member 102a is disposed in a region where semiconductor element 101 is mounted. A total of 15 element bonding members 102a, arranged three in the up-down direction and five in the left-right direction in FIG. 2, is disposed between one semiconductor element 101 and metal heat transfer plate 103a. Element bonding member 102a is formed in a square small piece shape smaller than semiconductor element 101 in plan view. Element bonding members 102a adjacent to one another in the up-down direction and left-right direction in FIG. 2 are disposed at even intervals.

Lead frame bonding member 102b is disposed in a region where lead frame 106 is mounted. Two lead frame bonding members 102b arranged in the up-down direction in FIG. 2 are disposed between one lead frame 106 and metal heat transfer plate 103a. Lead frame bonding member 102b is formed in the same shape as element bonding member 102a in plan view. Two lead frame bonding members 102b for bonding lead frame 106 are disposed at the same interval as element bonding members 102a adjacent to each other.

The shape of element bonding member 102a and lead frame bonding member 102b in plan view is not limited to a square shape, but may be a polygonal shape such as a rectangular shape, a triangular shape and a pentagon shape, or a circular shape. Preferably, the length of element bonding member 102a in each of the up-down direction (first direction) and the left-right direction (second direction) in FIG. 2 is 0.2 mm to 1.0 mm. If the length of element bonding member 102a in each of the up-down direction and left-right direction is smaller than 0.2 mm, the workability for disposing element bonding member 102a may be poor due to excessively small element bonding member 102a. On the other hand, if the length of element bonding member 102a in each of the up-down direction and left-right direction is greater than 1.0 mm, the non-uniformity of the volatilization of the organic solvent in each element bonding member 102a may increase due to excessively large element bonding member 102a. Preferably, the length of lead frame bonding member 102b in the up-down direction (first direction) and left-right direction (second direction) in FIG. 2 is 0.2 mm to 1.0 mm for the same reason as element bonding member 102a. In addition, the interval of element bonding members 102a arranged in the up-down direction in FIG. 2 may be different from the interval of element bonding members 102a arranged in the left-right direction.

Preferably, the interval between element bonding members 102a adjacent to each other is 0.1 mm to 1.0 mm. If the interval between element bonding members 102a is smaller than 0.1 mm, the organic solvent of element bonding member 102a may be less volatilized due to element bonding members 102a excessively close to each other. On the other hand, if the interval between element bonding members 102a is greater than 1.0 mm, it is necessary to reduce the area of each element bonding member 102a to dispose the same number of element bonding members 102a illustrated in FIG. 2. In view of this, the bonding strength of each element bonding member 102a may be reduced. Preferably, the interval of lead frame bonding members 102b adjacent to each other is also 0.1 mm to 1.0 mm for the same reason as element bonding member 102a.

### Method for Manufacturing Semiconductor Module

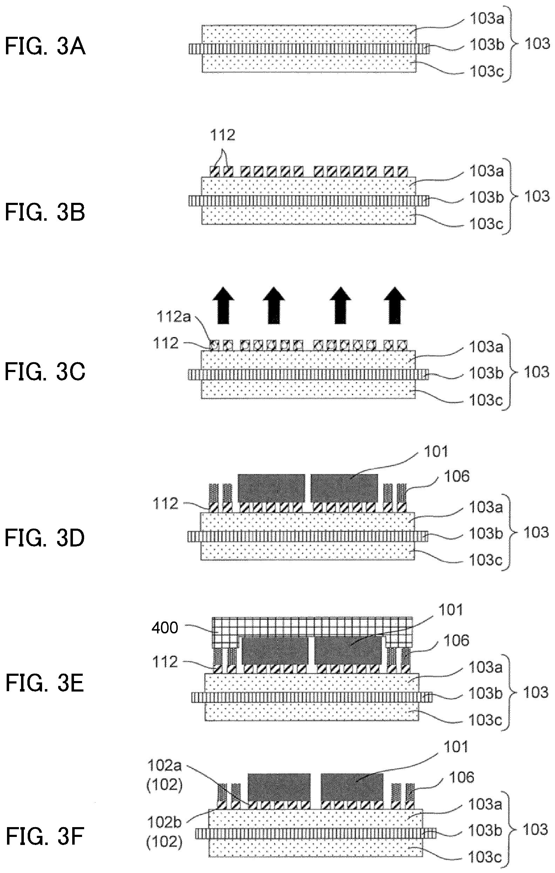

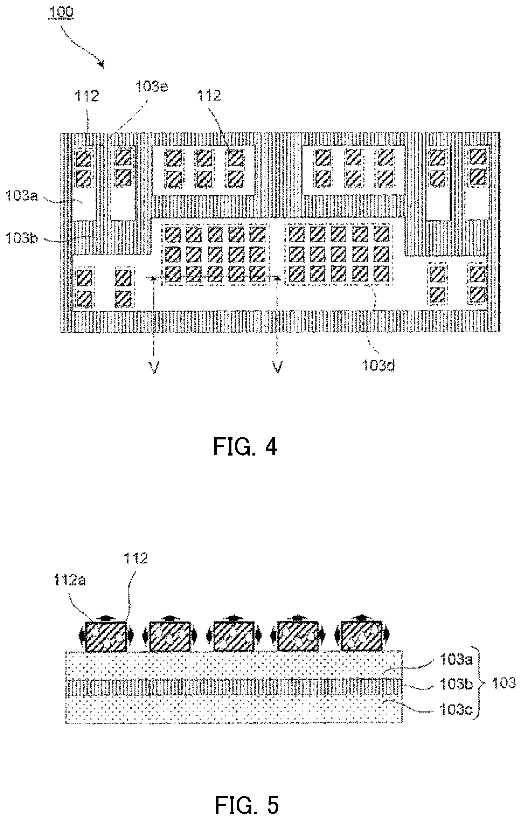

Next, a method for manufacturing semiconductor module 100 is described. FIGS. 3A to 3F are explanatory diagrams of the method for manufacturing the semiconductor module in a cross-section taken along line III-III of FIG. 2. FIG. 4 is a plan view illustrating a state after application of a sintering bonding material.

First, as illustrated in FIG. 3A, substrate member 103 composed of metal heat transfer plate 103a, insulation substrate 103b and metal heat dissipation plate 103c is prepared.

Next, as illustrated in FIG. 3B, sintering bonding material 112 is applied to arrangement positions of element bonding member 102a and lead frame bonding member 102b on metal heat transfer plate 103a. Sintering bonding material 112 is a sinterable metal nano-bonding material in a paste form obtained by dispersing nanoparticles with a surface protective film composed of an organic material in organic solvent.

A stabilizer is attached to the surface of the nanoparticles making up sintering bonding material 112 for the purpose of preventing the condensation and reaction of the nanoparticles. Further, sintering bonding material 112 is provided in the form of a paste by adding an organic solvent for the purpose of improving the applicability (i.e., printing property) to the rear electrode of semiconductor element 101, and improving the tackiness for holding the component before the sintering. Sintering bonding material 112 in the form of a paste contains approximately 90wt.% of nanoparticles composed of a metal such as silver, and, as a remaining part, an organic solvent such as carveol and perillyl alcohol and a stabilizer such as an amine compound. When sintering bonding material 112 is heated, the organic shell is decomposed and the low temperature sintering function of nanoparticles is developed. When the bonding temperature is maintained for a predetermined time, bonding of the nanoparticles to the bonded material progresses along with sintering of the nanoparticles, and finally metals are bonded through the metal sintering layer in a bulk form.

Sintering bonding material 112 is applied by a common mask printing method using a metal mask and a squeegee, for example. Openings with a uniform size are formed in the metal mask in the region for applying sintering bonding material 112. By applying sintering bonding material 112 on the metal mask and scraping it with the squeegee, sintering bonding material 112 with a desired size and thickness is applied at a desired position on metal heat transfer plate 103a. For example, by using a metal mask with an opening size of 0.5 mm × 0.5 mm, an opening interval of 0.2 mm, and a thickness of 100 µm, sintering bonding material 112 with a plan size of approximately 0.5 mm × 0.5 mm and a thickness of approximately 100 µm is applied.

When the application of sintering bonding material 112 is completed, sintering bonding material 112 is dried by pre-drying sintering bonding material 112 so as to evaporate organic solvent 112a contained in sintering bonding material 112 as illustrated in FIG. 3C. The pre-drying is performed at a temperature of approximately 50°C to 70°C for approximately one to 60 minutes.

When the drying of sintering bonding material 112 is completed, semiconductor element 101 and lead frame 106 are placed on sintering bonding material 112 as illustrated in FIG. 3D.

Next, as illustrated in FIG. 3E, pressing is performed with jig 400 from above semiconductor element 101 and lead frame 106 such that sintering bonding material 112 has a desired thickness. For example, sintering bonding material 112 is pressed such that all sintering bonding materials 112 have a thickness of approximately 50 µm.

Next, in the state where sintering bonding material 112 is pressed with jig 400, the sintering of sintering bonding material 112 is performed by semiconductor element 101, heating sintering bonding material 112 and substrate member 103 at a temperature of 250°C to 310°C for 30 to 240 minutes, and thus element bonding member 102a and lead frame bonding member 102b are formed.

Next, as illustrated in FIG. 3F, semiconductor element 101, element bonding member 102a, lead frame bonding member 102b and substrate member 103 are cooled, and then jig 400 is detached. Thereafter, by a known method, metal heat dissipation plate 103c and heat sink 105 are bonded by using heat dissipation member 104, and semiconductor module 100 is completed.

### Effects of First Embodiment

Since element bonding member 102a and lead frame bonding member 102b disposed on metal heat transfer plate 103a have the same shape, the reduction speed of the organic solvent in the pre-drying (the residual amount of the organic solvent after the pre-drying for a predetermined time) can be uniformized for all sintering bonding materials 112, and the non-uniformity in dried state of sintering bonding material 112 after the pre-drying can be suppressed. As a result, crack in element bonding member 102a and lead frame bonding member 102b due to the dried state of sintering bonding material 112 after the pre-drying can be suppressed. Thus, semiconductor module 100 that can suppress bonding defects of semiconductor element 101 and lead frame 106, and substrate member 103 can be provided. Furthermore, since voids in semiconductor element 101 and lead frame 106 are reduced, the heat-dissipation property of semiconductor module 100 can be improved.

Now, the reason that semiconductor module 100 of the present disclosure can provide the above-mentioned effects is described. FIG. 4 is a plan view illustrating a state after application of a sintering bonding material. FIG. 5 is a sectional view taken along line V-V of FIG. 4.

As described above, an organic solvent is added to sintering bonding material 112 for the purpose of ensuring the printing property for applying the paste to the electrode, and the tackiness for holding the components before the sintering. It should be noted that the organic solvent remaining in sintering bonding material 112 at the start of the sintering may result in generation of voids. As such, it is necessary to reduce the content of the organic solvent in advance through the pre-drying before the sintering. Therefore, the pre-drying step illustrated in FIG. 3C is performed. To reduce the voids generated in sintering bonding material 112 after the sintering as much as possible, it is important to volatilize organic solvent 112a contained in sintering bonding material 112 in the pre-drying until the tack strength of sintering bonding material 112 becomes a minimum required strength.

When the pre-drying is performed, organic solvent 112a volatilizes to the outside from the top surface and side surface of sintering bonding material 112 while moving inside sintering bonding material 112 as illustrated in FIG. 5. As such, the greater the size of sintering bonding material 112, the greater the moving length in the direction from the inside to the lateral side, and the less organic solvent 112a to be volatilized. As a result, if the plan sizes of sintering bonding materials 112 disposed on metal heat transfer plate 103a differ depending on the size or type of the member disposed thereon, the following problem is caused, for example. Specifically, the non-uniformity in amount of organic solvent 112a remaining inside sintering bonding material 112 after the pre-drying, i.e., the dried state of sintering bonding material 112, easily occur.

On the other hand, in the first embodiment, as illustrated in FIGS. 4 and 5, sintering bonding materials 112 on metal heat transfer plate 103a are formed in small piece shapes disposed at a predetermined interval and having the same size in plan view regardless of the size and type of the member disposed on it. More specifically, element bonding region 103d indicated by the dashed line where semiconductor element 101 is bonded and lead frame bonding region 103e indicated by the dashed line where lead frame 106 is bonded are different in plan size, but sintering bonding materials 112 of small piece shapes with the same plan size are disposed at a predetermined interval in element bonding region 103d and lead frame bonding region 103e. Thus, the reducing speed (reduction amount per unit time) of organic solvent 112a from each sintering bonding material 112 during the pre-drying, and the final reduction amount from each sintering bonding material 112, i.e., the amount of organic solvent 112a remaining in each sintering bonding material 112, can be uniformized. That is, the non-uniformity in dried state of sintering bonding material 112 after the pre-drying can be reduced. Thus, crack in element bonding member 102a and lead frame bonding member 102b due to the dried state of sintering bonding material 112 after the pre-drying can be suppressed, and the bonding defects of semiconductor element 101 and lead frame 106, and substrate member 103 can be suppressed.

Note that the arrangement of sintering bonding materials 112 with the even shape is not limited to the arrangement at an even interval as illustrated in FIG. 4. The interval between sintering bonding materials 112 can be selected as necessary in accordance with the circuit pattern of metal heat transfer plate 103a and the desired heat resistance. In addition, while element bonding member 102a is formed in a square small piece shape smaller than semiconductor element 101 in plan view, it may be formed in substantially the same quadrangular shape as semiconductor element 101 in plan view. In addition, sintering bonding materials 112 may not have small piece shapes with exactly the same plan size, but may have small piece shapes with the same volume.

### Second Embodiment

A second embodiment of the present disclosure is described below. Note that the same configurations as those of the first embodiment are denoted with the same names and reference numerals, and the description thereof is omitted or simplified.

### Structure of Semiconductor Module

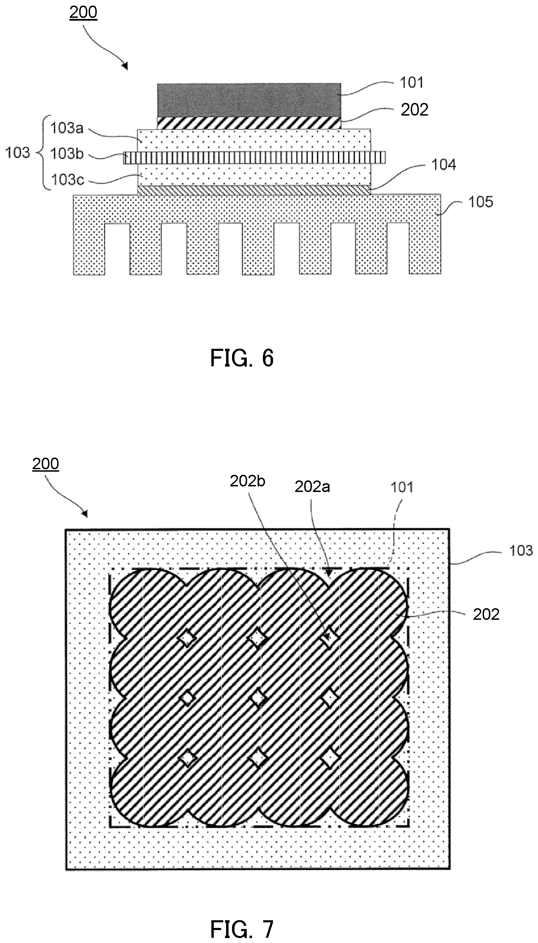

First, a structure of a semiconductor module of the second embodiment is described. FIG. 6 is a longitudinal sectional view of the semiconductor module.

As illustrated in FIG. 6, semiconductor module 200 includes semiconductor element 101, element bonding member 202, substrate member 103, heat dissipation member 104, and heat sink 105. Note that in FIG. 6, the illustration of the signal terminal and the power source terminal of semiconductor element 101 is omitted.

An electrode not illustrated in the drawing is formed at the bottom surface of semiconductor element 101. The electrode is composed of a metalized layer formed of nickel plating and gold plating so that semiconductor element 101 is firmly bonded to element bonding member 202. Note that in the second embodiment, semiconductor module 200 includes one semiconductor element 101, but semiconductor module 200 may include a plurality of semiconductor elements 101.

Element bonding member 202 is formed through sintering of a sintering bonding material. Element bonding member 202 includes a sintered metal formed through sintering of nanoparticles. With the sintered metal mainly composed of silver, the thermal conductivity of element bonding member 202 can be increased. In addition, with the sintered metal mainly composed of copper, the thermal conductivity of element bonding member 202 can be increased, while reducing the cost than using silver. Further, with the sintered metal mainly composed of nickel, the mechanical strength of element bonding member 202 can be increased. In addition, with the sintered metal mainly composed of gold, the stress absorption through elastic deformation of element bonding member 202 can be increased. When metal particles are atomized to a nanometer size, the proportion of atoms with high surface energy on the particle surface increases. In addition, when the particle size is small, the fusing point is low, and sintering at a temperature extremely lower than the fusing point in bulk can be achieved. Element bonding member 202 bonds semiconductor element 101 and substrate member 103. Specific configurations of element bonding member 202 are described later.

Semiconductor element 101 is bonded to metal heat transfer plate 103a of substrate member 103 with element bonding member 202. In addition, metal heat transfer plate 103a is connected to the electrode of the top surface semiconductor element 101 with a wire not illustrated in the drawing. In addition, metal heat transfer plate 103a is bonded to a lead frame not illustrated in the drawing. Through the lead frame, the power is supplied to semiconductor element 101 and the communication between semiconductor element 101 and the external apparatus is performed. A metalized layer not illustrated in the drawing is formed at metal heat transfer plate 103a so that metal heat transfer plate 103a is firmly bonded to element bonding member 202.

Heat dissipation member 104 prevents the malfunction and fracture of semiconductor module 200 due to the temperature rise of semiconductor element 101 by widely transferring, to the surrounding portions, the heat emitted by semiconductor element 101.

Next, specific configurations of element bonding member 202 are described. FIG. 7 is a plan view illustrating a shape of the element bonding member of the semiconductor module.

As illustrated in FIG. 7, element bonding member 202 is formed in substantially the same quadrangular shape as semiconductor element 101 in plan view. In plan view, element bonding member 202 is formed in a shape a total of 16 overlapping circles, four in the up-down direction and four in the left-right direction in FIG. 7. Notch 202a and through hole 202b are formed in element bonding member 202.

Notch 202a is formed between semiconductor element 101 and substrate member 103. Three notches 202a are formed along each of the four sides of semiconductor element 101 at even intervals. Notch 202a is formed in the shape of an isosceles triangle with circular-arc shaped equal sides. With notches 202a, the outer periphery of element bonding member 202 has a shape obtained by connecting a plurality of circular arcs. Through hole 202b is formed between semiconductor element 101 and substrate member 103. Through hole 202b is formed so as not to be connected to notch 202a. Three through holes 202b are formed at even intervals on a straight line connecting notches 202a arranged in the up-down direction in FIG. 7. Through hole 202b is formed in a substantially square shape with four sides of a circular arc shape. Note that at least one of notch 202a and through hole 202b may be formed outside semiconductor element 101 in plan view. In addition, through hole 202b may be connected to notch 202a.

Preferably, notch 202a has a bottom side with a length of 0.2 mm to 7 mm, and an equal side with a length of 1 mm to 5 mm. Preferably, the length of each side of through hole 202b is 0.1 mm to 3.5 mm. Note that in the second embodiment, 12 notches 202a are formed in the same shape, but one or more of these notches 202a may have a shape different from other notches 202a. In addition, in the second embodiment, nine through holes 202b have the same shape, but one or more of these through holes 202b may have different shapes than other through holes 202b. The shape of element bonding member 202 may be selected as necessary in accordance with the circuit pattern of metal heat transfer plate 103a and the desired heat resistance.

### Method for Manufacturing Semiconductor Module

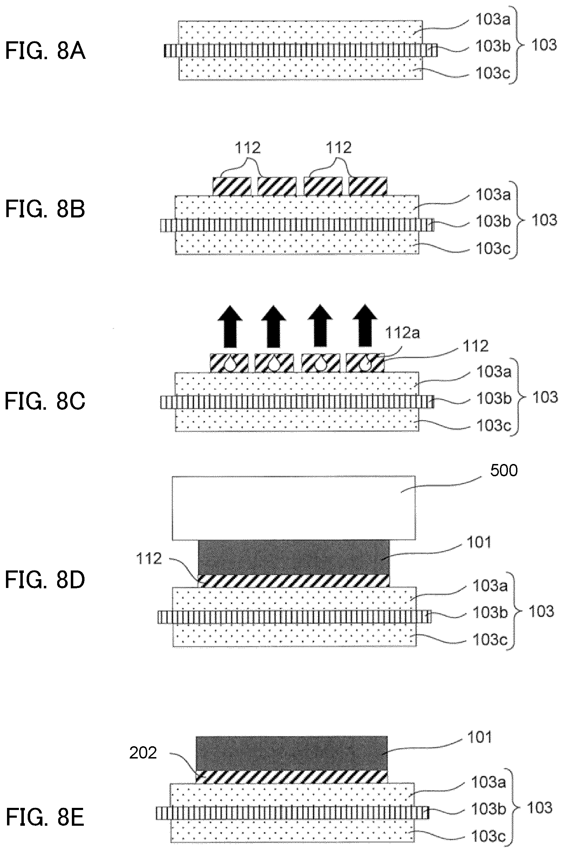

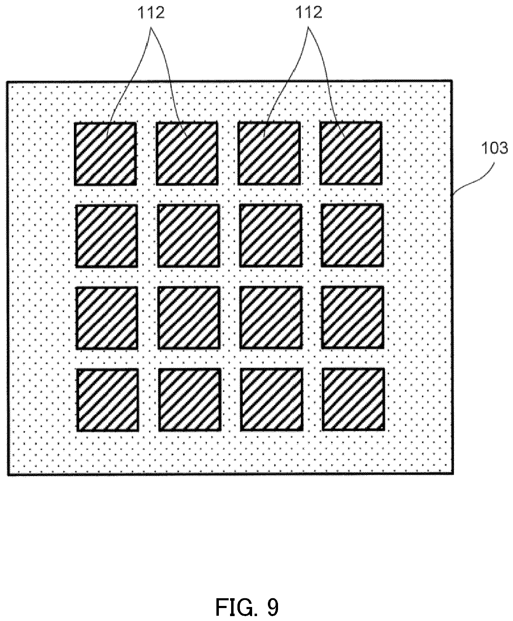

Next, a method for manufacturing semiconductor module 200 according to the second embodiment is described. FIGS. 8A to 8E are explanatory diagrams of a method for manufacturing a semiconductor module. FIG. 9 is a plan view illustrating a state after application of a sintering bonding material.

First, as illustrated in FIG. 8A, substrate member 103 composed of metal heat transfer plate 103a, insulation substrate 103b and metal heat dissipation plate 103c is prepared.

Next, as illustrated in FIG. 8B, sintering bonding material 112 is applied onto one main surface of metal heat transfer plate 103a.

At this time, a total of 16 quadrangular-shaped sintering bonding materials 112, four in the up-down direction and four in the left-right direction in FIG. 9, is applied. Specifically, sintering bonding materials 112 are applied such that a plurality of small pieces with a predetermined size is disposed at a predetermined interval. Preferably, the small piece is a quadrangle with one side of 0.5 mm to 5 mm, more preferably a quadrangle with one side of 0.5 mm to 2 mm. In addition, preferably, the interval between the small pieces adjacent to each other is 0.1 mm to 0.3 mm, more preferably 0.1 mm to 0.2 mm. Note that the shape of the small piece may be square, rectangular, circle or ellipse.

Sintering bonding material 112 is applied onto metal heat transfer plate 103a as to have a predetermined size and thickness through a dispenser application or a common mask printing method using a metal mask and a squeegee. The applied sintering bonding material 112 has a thickness of approximately 100 µm.

Upon completion of the application of sintering bonding material 112, sintering bonding material 112 is dried by evaporating organic solvent 112a contained in sintering bonding material 112 through pre-drying of sintering bonding material 112, as illustrated in FIG. 8C. The pre-drying is performed at a temperature of approximately 50°C to 70°C for approximately one to 60 minutes. Note that the pre-drying may not be performed in the case where sintering bonding material 112 contains a relatively small amount of organic solvent 112a and has sufficient applicability and tackiness.

When the drying of sintering bonding material 112 is completed, semiconductor element 101 is placed on sintering bonding material 112 and pressing is performed with jig 500 from above semiconductor element 101 such that sintering bonding material 112 has a desired thickness as illustrated in FIG. 8D. Through the pressing of sintering bonding material 112, sintering bonding materials 112 with the small piece shape illustrated in FIG. 9 are expanded and the small pieces adjacent to one another are coupled into one island shape. Note that in the second embodiment, "island shape" means a shape that can be regarded as a circular shape, an elliptical shape or a polygonal shape. As a result, sintering bonding material 112 has the same shape as element bonding member 202 of semiconductor module 200 where notch 202a and through hole 202b are formed as illustrated in FIG. 7.

Next, element bonding member 202 is formed by sintering sintering bonding material 112 by heating semiconductor element 101, sintering bonding material 112 and substrate member 103 at 250°C to 310°C for 30 to 240 minutes in the state where sintering bonding material 112 is pressed with jig 500.

Next, as illustrated in FIG. 8E, after cooling semiconductor element 101, element bonding member 202 and substrate member 103, jig 500 is detached. Thereafter, metal heat dissipation plate 103c and heat sink 105 are bonded by a known method with heat dissipation member 104, and thus semiconductor module 200 is completed.

### Effects of Second Embodiment

Sintering bonding material 112 with a shape of a plurality of small pieces disposed and separated at a predetermined interval are pressed with jig 500 into one island shape, and then sintering is performed. Here, when sintering bonding material 112 with a shape of a plurality of small pieces is sintered, organic solvent 112a contained in sintering bonding material 112 on the lower periphery side of semiconductor element 101 is reduced faster than organic solvent 112a contained in sintering bonding material 112 on the lower center side, and consequently crack may occur at the element bonding member formed on the lower periphery side. By performing sintering after forming sintering bonding material 112 with a shape of a plurality of small pieces into one island shape as in the second embodiment, the reduction speed of organic solvent 112a in the entire sintering bonding material 112 can be uniformized, and the occurrence of crack in element bonding member 202 can be suppressed. In this manner, semiconductor module 200 in which the bonding defects of semiconductor element 101 and substrate member 103 is suppressed can be provided. Note that as long as sintering bonding materials 112 with the shape of the plurality of small pieces are coupled with each other into one piece, the reduction speed of organic solvent 112a in the entire sintering bonding material 112 can be uniformized even when they do not have an island shape. Therefore, the shape obtained by coupling sintering bonding materials 112 of the shape of the plurality of small pieces may not be an island shape. It should be noted that the island shape can more uniformize the reduction speed of organic solvent 112a in the entire sintering bonding material 112.

In addition, since sintering bonding material 112 is pre-dried before sintering sintering bonding material 112, the reduction amount of organic solvent 112a of each sintering bonding material 112 can be uniformized, and the dried state before the sintering can be uniformized.

In addition, since sintering bonding material 112 with one island shape is formed by pressing and coupling sintering bonding material 112 with a shape of a plurality of small pieces, sintering bonding material 112 can be expanded to the region near the corner of semiconductor element 101 than in a case of pressing sintering bonding material 112 with a single small piece shape. Further, the contact area of element bonding member 202, and semiconductor element 101 and substrate member 103 can be increased than in a case where the bonding parts with the shape of a plurality of small pieces are separated. Thus, the contact area of element bonding member 202, and semiconductor element 101 and substrate member 103 can be increased, and the heat-dissipation property of semiconductor element 101 can be improved.

### Third Embodiment

Next, a third embodiment of the present disclosure is described.

### Structure of Semiconductor Module

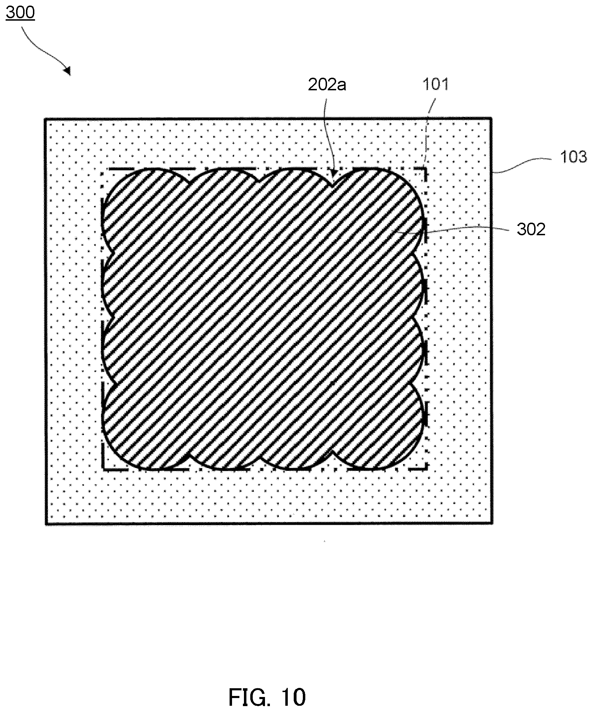

First, a structure of the semiconductor module according to the third embodiment is described. FIG. 10 is a plan view illustrating a shape of the element bonding member of the semiconductor module.

As illustrated in FIG. 10, semiconductor module 300 according to the third embodiment differs from semiconductor module 200 of the second embodiment in that through hole 202b is not formed in element bonding member 302, but the other structures are the same as those of semiconductor module 200. Also in the third embodiment, 12 notches 202a are formed in the same shape, but one or more of these notches 202a may be formed in a shape different from other notches 202a. The shape of element bonding member 302 can be selected as necessary in accordance with the circuit pattern of metal heat transfer plate 103a and the desired heat resistance.

### Method for Manufacturing Semiconductor Module

Next, a method for manufacturing the semiconductor module according to the third embodiment is described. Note that the description for the same steps as those of the second embodiment are simplified.

First, the steps illustrated in FIGS. 8A to 8B are performed. In the steps after these steps, the conditions are changed from those of the steps performed in the second embodiment, and thus element bonding member 302 is formed. As such a formation method for element bonding member 302, the following two methods may be used.

In the first formation method, after the pre-drying illustrated in FIG. 8C is performed under the same condition as in the second embodiment, the condition of the step of pressing sintering bonding material 112 with jig 500 illustrated in FIG. 8D is changed from the condition of the second embodiment. More specifically, sintering bonding material 112 is pressed such that the thickness of sintering bonding material 112 is thinner than in the second embodiment. Through such a pressing, the expansion of sintering bonding material 112 with the small piece shape becomes greater than the expansion in the second embodiment, and the same shape as element bonding member 302, which includes notch 202a but does not include through hole 202b, is obtained. Thereafter, element bonding member 302 of the third embodiment is formed by performing the sintering under the same condition as in the second embodiment.

In the second formation method, the condition of the pre-drying illustrated in FIG. 8C is changed from the condition of the second embodiment. More specifically, the pre-drying is performed such that the evaporation amount of organic solvent 112a is smaller than the evaporation amount of the second embodiment, i.e., the residual amount of organic solvent 112a is larger than the residual amount of the second embodiment. Next, the step of pressing sintering bonding material 112 with jig 500 illustrated in FIG. 8D is performed under the same condition as in the second embodiment. Through this pressing, sintering bonding material 112 has the same shape as that of element bonding member 202 with notch 202a and through hole 202b illustrated in FIG. 7. Thereafter, the sintering is performed under the same condition as in the second embodiment. Through this sintering, the evaporation amount of organic solvent 112a from sintering bonding material 112 increases than in the second embodiment, the thickness of element bonding member 302 formed after the sintering becomes thinner than element bonding member 202 of the second embodiment, and the portion corresponding to through hole 202b is eliminated in the process of the thinning. As a result, element bonding member 302 of the third embodiment is formed.

After element bonding member 302 is formed, the steps subsequent to the step illustrated in FIG. 8E are performed under the same conditions as in the second embodiment, and thus semiconductor module 300 is completed.

### Effects of Third Embodiment

According to the third embodiment, as in the second embodiment, semiconductor module 300 that can suppress the bonding defects of semiconductor element 101 and substrate member 103 can be provided. Since through hole 202b is not formed in element bonding member 302, the bonding area of element bonding member 302, and semiconductor element 101 and substrate member 103 can be increased, and the heat-dissipation property of semiconductor element 101 can be further improved in comparison with semiconductor module 200 of the second embodiment.

### Overview of Second and Third Embodiments

(1) The semiconductor module of the present disclosure includes a semiconductor element, a substrate member, and an element bonding member that bonds the semiconductor element and the substrate member and includes a sintered metal, and a notch is formed at the outer periphery of the element bonding member. (2) The semiconductor module according to (1) in which the notch is formed between the semiconductor element and the substrate member. (3) The semiconductor module according to (1) or (2) in which a through hole is formed in the element bonding member. (4) The semiconductor module according to (3) in which the through hole is formed between the semiconductor element and the substrate member. (5) The semiconductor module according to (3) or (4) in which the through hole is formed so as not to be connected to the notch. (6) The semiconductor module according to any one of (1) to (5) in which the sintered metal is formed through sintering of metal particles with a nanometer size. (7) The semiconductor module according to any one of (1) to (6) in which the semiconductor element is a power semiconductor element. (8) In the method for manufacturing the semiconductor module of the present disclosure, the element bonding member is formed by applying sintering bonding material in a shape of a plurality of small pieces separated from each other on the main surface of the substrate member, placing a semiconductor element on the sintering bonding material, pressing the semiconductor element to the substrate member to expand the sintering bonding material and couple the sintering bonding material, and sintering the coupled sintering bonding material. (9) In the method for manufacturing the semiconductor module according to (8), after the sintering bonding material is pre-dried, the semiconductor element is placed on the sintering bonding material. (10) In the method for manufacturing the semiconductor module according to (8) or (9), the coupled sintering bonding material has a plurality of notches at the outer periphery portion.

### Modifications of Second and Third Embodiments

Needless to say, the present disclosure is not limited to those of the above-described embodiments, and various variations may be added within the scope that does not deviate from the intent of the disclosure.

For example, an element bonding member similar to element bonding members 202 and 302 may be used for bonding a lead frame for the connection of the power source to the power source terminal of semiconductor element 101 and the signal transmission to the signal terminal, and the circuit pattern of metal heat transfer plate 103a. In addition, solder, Sn-based alloys and the like may be used for the material for forming element bonding members 202 and 302. Further, element bonding members 202 and 302 may include a sintered metal through sintering of particles with a micrometer size mainly composed of a metal such as silver, copper, nickel and gold.

This application is entitled to and claims the benefit of Japanese Patent Application No. 2021-077596 filed on April 30, 2021, and Japanese Patent Application No. 2021-077623 filed on April 30, 2021, the disclosure each of which including the specification, drawings and abstract is incorporated herein by reference in its entirety.

### Industrial Applicability

The present disclosure is applicable to a semiconductor module and a method for manufacturing the semiconductor module.

### Reference Signs List

100, 200, 300 Semiconductor module
101 Semiconductor element
102 Bonding part
102a Element bonding member
102b Lead frame bonding member
103 Substrate member
103a Metal heat transfer plate
103b Insulation substrate
103c Metal heat dissipation plate
103d Element bonding region
103e Lead frame bonding region
104 Heat dissipation member
105 Heat sink
106 Lead frame
112 Sintering bonding material
112a Organic solvent
202, 302 Element bonding member
202a Notch
202b Through hole
400, 500 Jig

## Claims

1. A semiconductor module comprising:
a semiconductor element;
a bonding part including a sintered metal;
a substrate member; and
a lead frame;
wherein the bonding part includes:
at least one element bonding member configured to bond the semiconductor element and a main surface of the substrate member, and
at least one lead frame bonding member configured to bond the lead frame and the main surface of the substrate member and having a small piece shape with the same volume as the element bonding member.

2. The semiconductor module according to claim 1, wherein the sintered metal is configured by sintering metal particles with a nanometer size.

3. The semiconductor module according to claim 1 or 2, wherein the sintered metal is mainly composed of silver, copper, nickel, or gold.

4. The semiconductor module according to any one of claims 1 to 3, wherein the semiconductor element is a power semiconductor element.

5. The semiconductor module according to any one of claims 1 to 4, wherein as viewed from the main surface side, the element bonding member and the lead frame bonding member have a length of 0.2 mm to 1.0 mm in a first direction, and a length of 0.2 mm to 1.0 mm in a second direction orthogonal to the first direction.

6. The semiconductor module according to any one of claims 1 to 5,
wherein the at least one element bonding member includes a plurality of element bonding members,
wherein the at least one lead frame bonding member includes a plurality of lead frame bonding members, and
wherein at least one of an interval between the plurality of element bonding members adjacent to each other, and an interval between the plurality of lead frame bonding members adjacent to each other is 0.1 mm to 1.0 mm.

7. A method for manufacturing a semiconductor module, comprising:
applying sintering bonding materials at a plurality of positions different from each other on a main surface of a substrate member such that the sintering bonding materials have shapes with the same volume as each other;
pre-drying the sintering bonding materials;
placing a semiconductor element on some of the sintering bonding materials applied on the main surface, and placing a lead frame on other of the sintering bonding materials applied on the main surface; and
bonding the semiconductor element and the substrate member and bonding the lead frame and the substrate member by sintering the sintering bonding materials.
